# EUROPEAN PATENT APPLICATION

(11) **EP 4 250 383 A1**
(43) Date of publication of application: **27.09.2023**
(21) Application number: 21894923.8
(22) Date of filing: 26.10.2021
(51) Int. Cl.: H01L 51/56, H01L 51/00, C23C 14/04, C23C 14/12

(54) **DEPOSITION MASK FOR OLED PIXEL DEPOSITION**

(30) Priority: 20.11.2020 KR 20200156462
(71) Applicant: LG Innotek Co., Ltd., Seoul 07796 (KR)
(72) Inventor: CHANG, Woo Young, Seoul 07796 (KR); KANG, Ji Hoon, Seoul 07796 (KR); KIM, Hae Sik, Seoul 07796 (KR)
(74) Representative: M. Zardi & Co S.A.
(86) International application number: PCT/KR2021/015068
(87) International publication number: WO 2022/108152

(57) **Abstract**

A deposition mask according to an embodiment comprises: a metal plate including an Fe-Ni-based alloy and including a first surface and a second surface opposite to the first surface, wherein the metal plate comprises a through-hole including a small-area hole on the first surface of the metal plate and a large-area hole on the second surface of the metal plate, the compressive stress of the first surface is greater than that of the second surface, the tensile stress of the second surface is greater than that of the first surface, the metal plate is bent toward the second surface, and a height difference between the highest point and the lowest point of the first surface has a value equal to or less than 3*µ*m.

## Description

### [Technical Field]

An embodiment relates to a deposition mask for OLED pixel deposition.

### [Background Art]

Display devices are applied to various devices. For example, display devices are applied not only to small devices such as smart phone and tablet PC, but also to large devices such as TV, monitor, and public display. In particular, recently, demand for ultra-high definition (UHD) of 500 pixels per inch (PPI) or more is increasing, and high-resolution display devices are being applied to small and large devices. Accordingly, interest in technology capable of implementing low power and high resolution is increasing.

Commonly used display devices are classified into liquid crystal display and organic light emitting diode according to driving methods.

The liquid crystal display is a display device driven by using a liquid crystal. A light source including a Cold Cathode Fluorescent Lamp (CCFL) or Light Emitting Diode (LED) is disposed under the liquid crystal. The liquid crystal display is driven by controlling the amount of light emitted from the light source using the liquid crystal disposed on the light source.

In addition, the organic light emitting diode is a display device driven by using an organic material. In the organic light emitting diode, the organic material serves as a light source. Therefore, the organic light emitting diode may be driven with low power since a separate light source is not required. In addition, the organic light emitting diode may express an infinite contrast ratio, has a response speed about 1000 times faster than that of the liquid crystal display, and has an excellent viewing angle. Accordingly, the organic light emitting diode is attracting attention as a display device that can replace liquid crystal display.

In particular, the organic material included in the light emitting layer of the organic light emitting diode may be deposited on the substrate by a deposition mask called a fine metal mask (FMM). The deposited organic material may be formed in a pattern corresponding to a pattern formed on the deposition mask to serve as a pixel. The deposition mask is generally made of an Invar alloy metal plate including iron (Fe) and nickel (Ni). In this case, through-holes penetrating the one surface and the other surface of the metal plate may be formed, and the through-holes may be formed at a position corresponding to the pixel pattern. Accordingly, organic materials such as red, green, and blue may pass through the through-holes of the metal plate and be deposited on the substrate, and a pixel pattern may be formed on the substrate.

Meanwhile, after the invar alloy metal plate used in the deposition mask undergoes a rolling process for modifying the thickness and surface of the metal plate, the through-holes may be formed in the metal plate.

In this case, when a rolling process is performed on the metal plate, surface waviness may be formed on the surface of the metal plate as the metal plate is bent while the stress distribution inside the metal plate is randomly changed. Accordingly, the length of the metal plate in the short axis direction is changed for each area, and the length of the long axis direction is also changed, thereby reducing the straightness of the metal plate.

Accordingly, when an organic material is deposited on an object to be deposited using the deposition mask having waviness, through-holes may deviate from desired positions. Alternatively, the thickness of the organic material in the deposition region of the deposition object may be deposited thinly, resulting in stains.

Therefore, there is a need for a new deposition mask capable of controlling the bending of the metal plate due to the rolling process of the metal plate and the waviness caused by the bending.

### [Disclosure]

### [Technical Problem]

An embodiment is to provide a deposition mask capable of controlling bending and having improved deposition efficiency.

### [Technical Solution]

A deposition mask comprising; a metal plate including an iron-nickel alloy and including a first surface and a second surface opposite to the first surface, wherein the metal plate includes through-holes including a small surface hole on the first surface of the metal plate and a large surface hole on the second surface, wherein a compressive stress of the first surface is greater than a compressive stress of the second surface, wherein a tensile stress of the second surface is greater than a tensile stress of the first surface, wherein an end of the metal plate is bent in the direction of the second surface, wherein a height difference between a highest point and a lowest point of the first surface is 3 µm or less.

### [Advantageous Effects]

The deposition mask according to the embodiment may control residual stress inside the deposition mask. In detail, the deposition mask according to the embodiment may control the distribution and size of compressive stress and tensile stress remaining inside the deposition mask.

Accordingly, in the deposition mask according to the embodiment, warpage of the deposition mask may be controlled. That is, the deposition mask according to the embodiment may control the bending direction, bending position, and bending size of the deposition mask.

Accordingly, the deposition region of the deposition mask may be maintained flat to have a curvature close to 0, and the non-deposition region may be maintained to have a greater curvature than the deposition region.

Therefore, when the deposition mask and the deposition substrate are in contact, a gap between the deposition region of the deposition mask and the deposition substrate may be minimized.

Accordingly, the deposition mask according to the embodiment can improve deposition efficiency by minimizing the gap between the deposition mask and the deposition substrate, thereby minimizing non-uniformity in deposition thickness.

### [Description of Drawings]

FIG. 1 is a cross-sectional view of an organic material deposition apparatus to which a deposition mask according to an embodiment is applied.
FIG. 2 is a cross-sectional view illustrating a contact relationship with a deposition substrate after a pretreatment process of a metal plate of the deposition mask.
FIG. 3 is a plan view for explaining a waviness of the deposition mask.
FIG. 4 is a view for explaining the pretreatment process of the metal plate of the deposition mask according to the embodiment.
FIG. 5 is a view for explaining a shape after the pretreatment process of the metal plate of the deposition mask according to the embodiment.
FIGS. 6 and 7 are scanning electron microscope (SEM) photographs of a first surface (FIG. 6) and a second surface (FIG. 7) after the pretreatment process for the metal plate of the deposition mask according to the embodiment.
FIG. 8 is a plan view of the deposition mask according to the embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and replaced. In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a deposition mask according to an embodiment will be described with reference to the drawings.

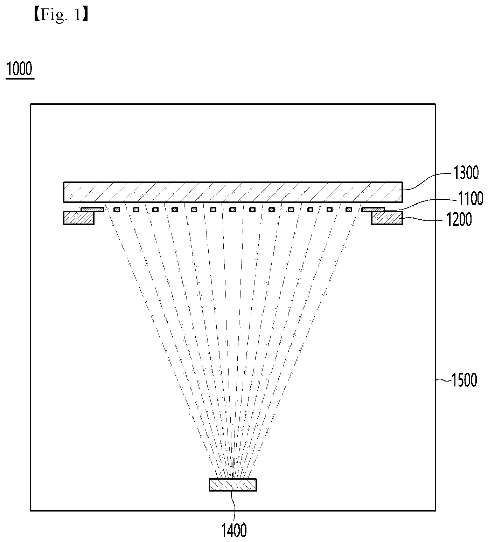

FIG. 1 is a cross-sectional view of an organic material deposition apparatus to which the deposition mask according to the embodiment is applied.

Referring to FIG. 1, the organic material deposition apparatus 1000 may include a deposition mask 1100, a mask frame 1200, a deposition substrate 1300, an organic material deposition container 1400, and a vacuum chamber 1500.

The deposition mask 1100, the mask frame 1200, the deposition substrate 1300, and the organic material deposition container 1400 may be accommodated in the vacuum chamber 1500. Accordingly, the deposition process using the deposition mask 1100 may be performed in a vacuum atmosphere.

The deposition substrate 1300 may be a substrate used for manufacturing a display device. For example, the deposition substrate 1300 may be a substrate for depositing organic materials for OLED pixel patterns. Red, green, and blue organic patterns may be formed on the deposition substrate 1300 to form pixels that are three primary colors of light. That is, an RGB pattern may be formed on the deposition substrate 1300.

The deposition mask 1100 may be disposed on one surface of the deposition substrate 1300. In detail, the deposition mask 1100 may be disposed on a deposition surface on which an organic material is deposited among both sides of the deposition substrate 1300 and fixed by the mask frame 1200.

Accordingly, the organic material passes through the through-holes TH formed in the deposition mask 1100. Accordingly, the organic material forming an RGB pattern may be deposited on the deposition surface of the deposition substrate 1300.

The organic material deposition container 1400 may be a crucible. The organic material may be disposed inside the crucible. In the vacuum chamber 1500, a heat source and/or current are supplied to the crucible which is the organic material deposition container 1400. Accordingly, the organic material may pass through the deposition mask 1100 and be deposited on the deposition surface of the deposition substrate 1300.

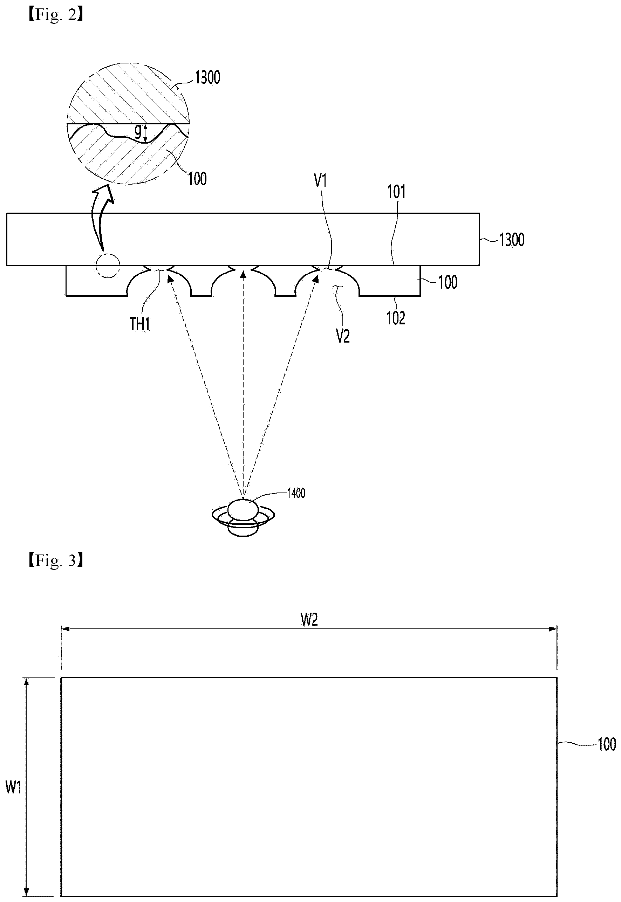

FIGS 2 and 3 are views for explaining the arrangement relationship between the deposition mask 1100 and the deposition substrate 1300.

Referring to FIG. 2, the deposition mask 1100 is disposed on the deposition surface of the deposition substrate 1300, and the deposition mask 1100 may be disposed in contact with the deposition surface of the deposition substrate 1300.

The deposition mask 1100 may be formed by forming a plurality of through holes TH in a metal plate 100 including iron and nickel. In detail, the deposition mask 1100 may be formed by forming the plurality of through-holes TH formed by an etching process in the metal plate 100 including an invar alloy including iron and nickel.

In detail, the metal plate 100 may include a first surface 101 and a second surface 102 opposite to each other. A small surface hole V1 may be formed on the first surface 101 of the metal plate 100, and a large surface hole V2 may be formed on the second surface 102 of the metal plate 100.

The large surface hole is disposed to face the organic material deposition container 1400 and is a region into which the deposition material of the organic material deposition container 1400 introduces. The small surface hole V1 may be a region through which the deposition material introduced from the large surface hole V2 passes.

The small surface hole V1 and the large surface hole V2 may be formed while partially penetrating the metal plate 100. For example, the depth of the small surface hole V1 may be smaller than the depth of the large surface hole V2. In addition, the small surface hole V1 and the large surface hole V2 may be disposed at positions overlapping each other in the thickness direction of the metal plate 100 and connected to each other.

Accordingly, a plurality of through holes TH formed by connecting the small surface hole V1 and the facing hole V2 may be formed in the metal plate 100.

The deposition mask 1100 may be disposed so that the small surface hole V1 of the deposition mask 1100 contacts the deposition surface of the deposition substrate 1300.

Before forming the through hole TH in the metal plate 100, a pretreatment process for reducing the thickness of the metal plate 100 and treating the surface of the metal plate 100 may be performed. Accordingly, the stress remaining inside the metal plate 100 by the pretreatment process, ie, the distribution of tensile stress and compressive stress, is randomly changed. As the metal plate is bent by this stress distribution, a waviness formed by the pretreatment process may be formed on the surface of the metal plate.

Conventionally, the thickness of the metal plate is reduced to a certain thickness by a rolling process in which the metal plate 100 is inserted between two rollers, and the surface roughness of the first and second surfaces of the metal plate is changed. However, since the rolling process proceeds in one direction, the stress distribution inside the metal plate is irregularly changed by the pressure applied in the direction of the first and second surfaces of the metal plate. The metal plate is bent in an irregular direction by the irregular residual stress distribution. As a result, waviness was formed on the surface of the metal plate.

The length and width of the metal plate may be changed by the waviness. For example, referring to FIG. 3, the short width W1 or long width W2 of the metal plate may be randomly changed for each region of the metal plate by the waviness. That is, the size of the metal plate in the width direction and the size of the metal plate in the longitudinal direction may be randomly changed for each region of the metal plate by the waviness. That is, the short width W1 defined as the size in the width direction of the metal plate and the long width W2 defined as the size in the longitudinal direction of the metal plate may be randomly changed for each region of the metal plate by the waviness.

Accordingly, referring to FIG. 2, when the deposition mask 1100 and the deposition substrate 1300 contact each other, the contact surface between the deposition mask 1100 and the deposition substrate 1300 is not completely in contact, and a gap g may be formed in some regions due to the waviness formed in the deposition mask 1100. The distribution and size of the gap g may increase as the waviness increases.

Accordingly, a first through hole TH formed in the deposition mask 1100 may be misaligned with the deposition region of the deposition substrate 1300. As a result, deposition efficiency after the deposition process may be reduced. In addition, since the thickness of the organic material passing through the deposition region of the metal plate varies from region to region, the thickness of the organic material pattern deposited on the deposition substrate becomes non-uniform.

Therefore, hereinafter, the deposition mask capable of solving the above problems will be described.

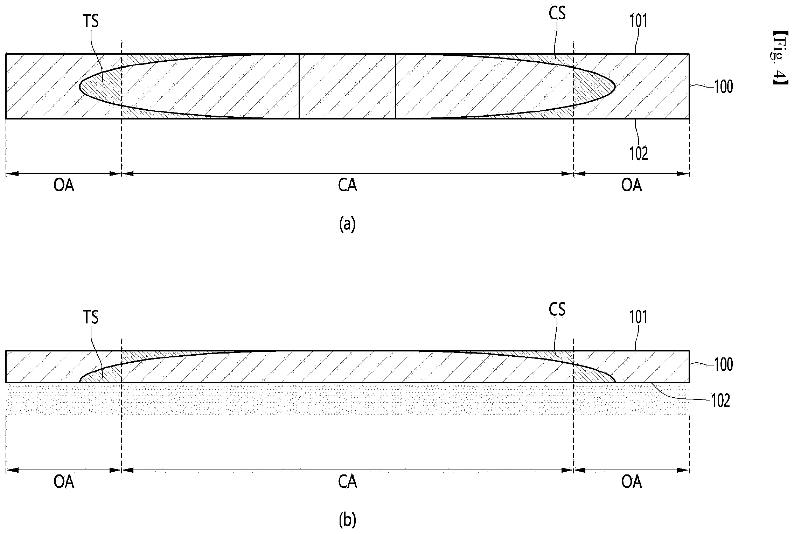

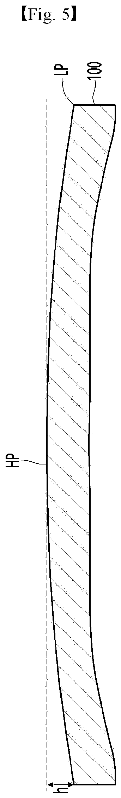

FIGS 4 and 5 are views for explaining stress distribution inside the metal plate after pretreatment and pretreatment of the metal plate of the deposition mask according to the embodiment.

Referring to FIG. 4, the metal plate 100 may be pretreated before forming the through-holes TH. This pretreatment may be a process of reducing the thickness of the metal plate and increasing the surface roughness of the metal plate in order to manufacture the deposition mask.

The deposition mask according to the embodiment may etch the first surface 101 or the second surface 102 of the metal plate 100. Accordingly, the thickness of the metal plate 100 may be reduced to a thickness that can be applied to the deposition mask.

For example, the deposition mask may form the thickness of the metal plate 100 to a thickness of 30 µm or less by etching the second surface 102 of the metal plate. Accordingly, the first surface 101 of the metal plate 100 may maintain the invar alloy surface, which is the raw material of the metal plate, and the second surface 102 may become an etched surface by etching.

Referring to FIG. 4, it can be seen that the stress distribution of the metal plate 100 of the deposition mask according to the embodiment is maintained uniformly even after the pretreatment process.

FIG. 4(a) is a cross-sectional view for explaining the internal stress distribution of the metal plate before the metal plate pretreatment process. FIG. 4(b) is a cross-sectional view for explaining the internal stress distribution of the metal plate after the metal plate pretreatment process.

Referring to FIG. 4(a), before the pretreatment of the metal plate 100, the inside of the metal plate 100 has compressive stress CS and tensile stress TS symmetrical to each other in the directions of the first surface 101 and the second surface 102. Thus, the metal plate 100 may be maintained in a flat state without bending.

That is, the compressive stress CS and the tensile stress TS remaining inside the metal plate 100 remain in symmetrical amounts in the first and second surfaces directions of the metal plate 100. Accordingly, the metal plate 100 is not bent in one direction by the compressive stress CS and the tensile stress TS, does not generate waviness, and may maintain a flat state.

Subsequently, referring to FIG. 4(b), a pretreatment process of the metal plate 100 may be performed. In detail, a process of etching the first surface 101 or the second surface 102 of the metal plate 100 may be performed.

For example, the thickness of the metal plate 100 may be reduced by etching the metal plate 100 from the second surface 102 toward the first surface 101. In detail, the metal plate 100 applied to the deposition mask may be manufactured by etching a thickness of 10% to 50% of the total thickness of the metal plate 100.

When the metal plate 100 is etched to a thickness of less than 10% or more than 50%, a difference in stress remaining in the first and second surfaces of the metal plate after etching is not large, and thus the metal plate may not be bent in a desired direction.

When the metal plate 100 is etched from the second surface 102 in the direction of the first surface 101, the compressive stress CS and the tensile stress TS remaining from the second surface 102 in the direction of the first surface 101 may be removed.

However, a separate force does not act in the direction of the second surface 102 from the first surface 101. Therefore, the compressive stress CS and tensile stress TS remaining from the first surface 101 toward the second surface 102 may be maintained in the distribution of tensile stress and compressive stress before pretreating the metal plate 100.

Accordingly, the stress distribution of the metal plate after pretreatment may be different compared to the stress distribution of the metal plate before pretreatment. In detail, after the pretreatment of the metal plate 100, the compressive stress of the first surface 101 of the metal plate may be greater than the compressive stress of the second surface. Also, the tensile stress of the second surface 102 may be greater than the tensile stress of the first surface.

In addition, after the pretreatment of the metal plate 100, the compressive stress of the central region CA of the metal plate is greater than the compressive stress of the outer region OA of the metal plate. Also, the tensile stress of the outer region OA may be greater than that of the central region CA.

Accordingly, the metal plate 100 may have a property of being compressed in a direction from the first surface 101 to the second surface 102. In addition, the metal plate may have a property of stretching from the central region to the outer region.

Accordingly, referring to FIG. 5, the metal plate 100 may be bent in the direction of the second surface 102 by the distribution of compressive stress and tensile stress of the first surface 101, the second surface 102, the central area CA, and the outer area OA. In detail, both ends of the metal plate 100 may be bent in the direction of the second surface 102. That is, the metal plate 100 may be bent so that the curvature gradually increases from the central region to the outer region. In detail, the metal plate 100 may have a shape in which the central region CA is flat and the outer region OA is bent.

Accordingly, the central region of the deposition mask 1100 where the deposition region is disposed is flattened so that the curvature is close to 0, and the outer region where the deposition region is not disposed is curved. Accordingly, when the deposition mask 1100 and the deposition substrate 1300 contact each other, a gap caused by waviness in a deposition region may be minimized.

Meanwhile, since the metal plate 100 is bent in one direction, the first surface 101 of the metal plate may have a highest point HP and a lowest point LP. That is, the first surface 101 of the metal plate may have a highest point HP in the central area CA of the metal plate 100 and a lowest point LP in the outer area OA.

In this case, a height difference h between the highest point HP and the lowest point LP may be about 3 µm or less. When the height difference h between the highest point HP and the lowest point LP exceeds 3 µm, the curvature increases in the central region of the first surface 101 of the metal plate. Accordingly, when the deposition mask 1100 and the deposition substrate 1300 contact each other, a gap area in which the deposition region of the metal plate disposed in the central region of the metal plate does not contact the deposition substrate 1300 is increased. Accordingly, the deposition efficiency of the deposition mask may decrease.

Meanwhile, the surface roughness of the first surface 101 and the surface roughness of the second surface 102 of the metal plate 100 may be different.

In detail, the surface roughness of the etched surface of the metal plate 100 may be smaller than that of the non-etched surface. Accordingly, as described above, when the second surface 102 of the metal plate 100 is etched, the surface roughness of the first surface 101 may be greater than that of the second surface 102.

In detail, the arithmetic average roughness (Ra) of the first surface 101 may be greater than the arithmetic average roughness (Ra) of the second surface 102. In addition, the ten point median height (Rz) of the first surface 101 may be greater than the ten point median height (Rz) of the second surface 102.

For example, the arithmetic average roughness (Ra) of the first surface in the longitudinal direction of the metal plate is 0.05 µm to 0.5 µm, and an arithmetic average roughness (Ra) of the first surface in the width direction of the metal plate is 0.05 µm to 0.5 µm. In addition, the arithmetic average roughness (Ra) of the second surface in the longitudinal direction of the metal plate is 0.05 µm to 0.2 µm, and an arithmetic average roughness (Ra) of the second surface in the width direction of the metal plate is 0.1 µm to 0.5 µm.

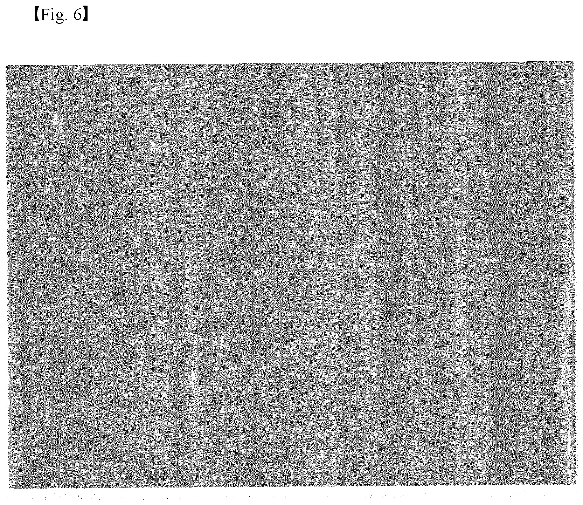

That is, as shown in FIG. 6, the first surface may have the roughness in a longitudinal direction and the roughness in a width direction of the metal plate almost similar to each other. Accordingly, no texture is formed on the surface of the first surface.

In addition, the ten point median height (Rz) of the first surface in the longitudinal direction of the metal plate is 1.0 µm to 3.0 µm, and a ten point median height (Rz) of the first surface in the width direction of the metal plate is 1.0 µm to 3.0 µm. In addition, the ten point median height (Rz) of the second surface in the longitudinal direction of the metal plate is 0.2 µm to 1.0 µm, and a ten point median height (Rz) of the second surface in the width direction of the metal plate is 1.0 µm to 3.0 µm.

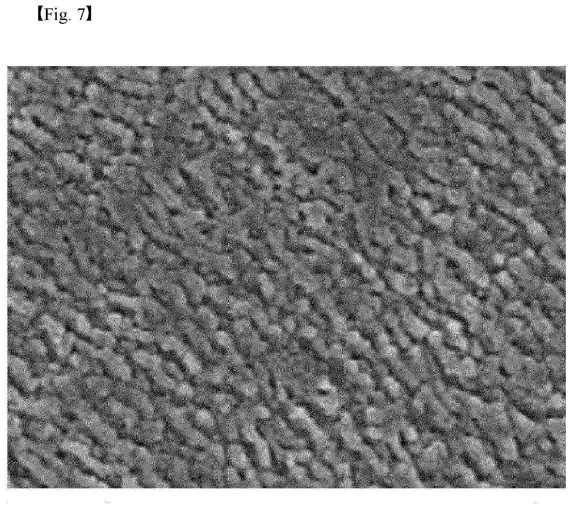

That is, as shown in FIG. 7, the roughness of the second surface in the longitudinal direction of the metal plate may be different from the roughness in the width direction. Accordingly, texture may be formed on the surface of the second surface.

That is, the difference between the arithmetic mean roughness (Ra) in the longitudinal direction on the first surface and the arithmetic mean roughness (Ra) in the width direction on the first surface may be smaller than the difference between the arithmetic mean roughness (Ra) in the longitudinal direction on the second surface and the arithmetic mean roughness (Ra) in the width direction on the second surface.

In addition, the difference between the ten point median height (Rz) in the longitudinal direction on the first surface and the ten point median height (Rz) in the width direction on the first surface may be smaller than the difference between the ten point median height (Rz) in the longitudinal direction on the second surface and the ten point median height (Rz) in the width direction on the second surface.

Accordingly, the surface shapes of the first surface and the second surface may differ depending on the texture.

Accordingly, the surface roughness of the first surface 101 on which the small surface hole V1 is formed may be greater than the surface roughness of the second surface 102 on which the large surface hole V2 is formed.

For example, the arithmetic mean roughness (Ra) of the first surface 101 may be 1.2 to 1.65 times the arithmetic mean roughness (Ra) of the second surface 102. In addition, the ten point median height (Rz) of the first surface 101 may be 1.2 to 1.65 times the ten point median height (Rz) of the second surface 102.

When the arithmetic mean roughness (Ra) or ten point median height (Rz) of the first surface 101 exceeds 1.65 times the arithmetic mean roughness (Ra) or ten point median height (Rz) of the second surface 102, the difference in adhesion to the photoresist may increase due to the difference in surface roughness between the first surface 101 and the second surface 102. Accordingly, etching uniformity of the first surface 101 and the second surface 102 may be reduced.

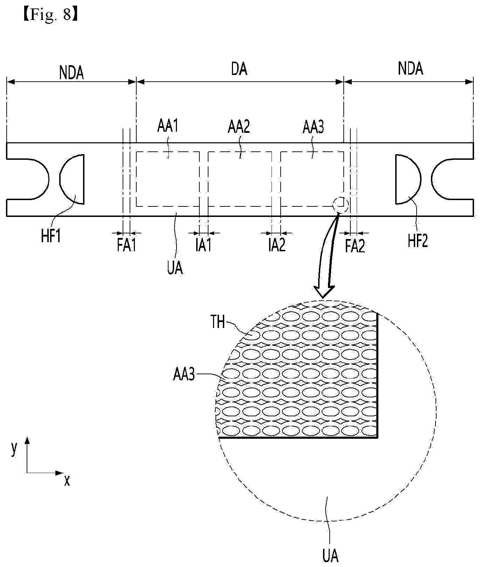

Hereinafter, referring to FIG. 8, the deposition mask to which the above-described pretreated metal plate is applied will be described.

FIG. 8 is a plan view of the deposition mask according to the embodiment.

Referring to FIG. 8, the deposition mask 1100 according to the embodiment may include a deposition region DA and a non-deposition region NDA.

The deposition region DA may be a region for forming a deposition pattern. That is, the deposition material may be deposited onto the deposition substrate by the deposition region of the deposition mask.

The deposition mask 1100 may include a plurality of deposition regions DA. For example, the deposition region DA may include an effective portion and an ineffective portion. In detail, the deposition region DA may include a plurality of effective portions in which a plurality of through-holes are formed to form a deposition pattern, and an ineffective portion UA in which no through-holes are formed. The plurality of through holes TH described above may be formed in the effective portion.

The plurality of effective portions may include a first effective portion AA1, a second effective portion AA2, and a third effective portion AA3, and may be spaced apart from each other by separation regions IA1 and IA2.

In the case of a small display device such as a smart phone, an effective portion of any one of a plurality of deposition regions of the deposition mask 1100 may be an effective portion for forming one display device. Alternatively, in the case of a large display device such as a TV, several effective portions of the deposition mask 1100 may be effective portions for forming one display device. Accordingly, since one deposition mask 1100 includes a plurality of effective portions, several display devices may be simultaneously formed. Accordingly, process efficiency may be improved by the deposition mask 1100 according to the embodiment.

The non-deposition region NDA may be disposed on both sides of the deposition region DA in the longitudinal direction. That is, the non-deposition region NDA may be disposed outside the deposition region DA in the longitudinal direction.

The non-deposition region NDA may be a region not involved in deposition. The non-deposition region NDA may include frame fixing regions FA1 and FA2 for fixing the deposition mask 1100 to the mask frame 1200. In addition, the non-deposition region NDA may include half-etched portions HF1 and HF2, open portions OA1 and OA2, and protruding portions PA1 and PA2.

The deposition region DA and the non-deposition region NDA may respectively correspond to positions of the central region CA and the outer region OA of the metal plate 100 described above. In detail, the deposition region DA may correspond to the central region CA of the metal plate 100. Also, the non-deposition region NDA may correspond to the outer region OA of the metal plate 100.

Accordingly, the deposition region DA of the deposition mask 1100 may be flat, and the non-deposition region NDA may be bent. In detail, both ends of the deposition mask 1100 may be bent. In detail, both ends of the deposition mask 1100 may be bent in the direction of the large surface hole. That is, the deposition mask 1100 may be bent in the direction of the large surface hole so that the curvature gradually increases while extending from the deposition region DA to the non-deposition region NDA.

Accordingly, the shape of the deposition mask 1100 is maintained such that the deposition region DA is flat so that the curvature is close to 0, and the non-deposition region NDA is curved. Accordingly, when the deposition mask 1100 and the deposition substrate 1300 are in contact, the gap between the deposition region and the deposition substrate 1300 may be minimized.

The deposition mask according to the embodiment may control residual stress inside the deposition mask. In detail, the deposition mask according to the embodiment may control the distribution and size of compressive stress and tensile stress remaining inside the deposition mask.

Accordingly, in the deposition mask according to the embodiment, warpage of the deposition mask may be controlled. That is, the deposition mask according to the embodiment may control the bending direction, bending position, and bending size of the deposition mask.

Accordingly, the deposition region of the deposition mask may be maintained flat to have a curvature close to 0, and the non-deposition region may be maintained to have a greater curvature than the deposition region.

Therefore, when the deposition mask and the deposition substrate are in contact, a gap between the deposition region of the deposition mask and the deposition substrate may be minimized.

Accordingly, the deposition mask according to the embodiment can improve deposition efficiency by minimizing the gap between the deposition mask and the deposition substrate, thereby minimizing non-uniformity in deposition thickness.

In addition, after forming the deposition mask, a separate stretching process for reducing the waviness of the deposition mask may be omitted.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A deposition mask comprising;
a metal plate including an iron-nickel alloy and including a first surface and a second surface opposite to the first surface,
wherein the metal plate includes through-holes including a small surface hole on the first surface of the metal plate and a large surface hole on the second surface,
wherein a compressive stress of the first surface is greater than a compressive stress of the second surface,
wherein a tensile stress of the second surface is greater than a tensile stress of the first surface,
wherein an end of the metal plate is bent in the direction of the second surface,
wherein a height difference between a highest point and a lowest point of the first surface is 3 µm or less.

2. The deposition mask of claim 1, wherein a compressive stress in a central region of the metal plate is greater than a compressive stress in an outer region of the metal plate; wherein a tensile stress in the outer region is greater than a tensile stress in the central region.

3. The deposition mask of claim 1, wherein an arithmetic average roughness of the first surface is greater than an arithmetic average roughness of the second surface.

4. The deposition mask of claim 1, wherein a ten point median height of the first surface is greater than a ten point median height of the second surface.

5. The deposition mask of claim 1, wherein a curvature of the metal plate increases while extending from a central region to an outer region of the metal plate.

6. The deposition mask of claim 1, wherein the metal plate includes a deposition region and a non-deposition region disposed outside the deposition region,
wherein the small surface hole and the large surface hole are disposed in the deposition region,
wherein a curvature increases while extending from the deposition region to the non-deposition region.

7. The deposition mask of claim 1, wherein a difference between an arithmetic mean roughness in the longitudinal direction on the first surface and an arithmetic mean roughness in the width direction on the first surface is smaller than a difference between an arithmetic mean roughness in the longitudinal direction on the second surface and an arithmetic mean roughness in the width direction on the second surface.

8. The deposition mask of claim 1, wherein a difference between a ten point median height in the longitudinal direction on the first surface and a ten point median height (Rz) in the width direction on the first surface is smaller than a difference between a ten point median height in the longitudinal direction on the second surface and a ten point median height in the width direction on the second surface.

9. The deposition mask of claim 1, wherein an arithmetic average roughness (Ra) of the first surface in the longitudinal direction of the metal plate is 0.05 µm to 0.5 µm, and an arithmetic average roughness (Ra) of the first surface in the width direction of the metal plate is 0.05 µm to 0.5 µm,
wherein an arithmetic average roughness (Ra) of the second surface in the longitudinal direction of the metal plate is 0.05 µm to 0.2 µm, and an arithmetic average roughness (Ra) of the second surface in the width direction of the metal plate is 0.1 µm to 0.5 µm,
wherein a ten point median height (Rz) of the first surface in the longitudinal direction of the metal plate is 1.0 µm to 3.0 µm, and a ten point median height (Rz) of the first surface in the width direction of the metal plate is 1.0 µm to 3.0 µm,
wherein a ten point median height (Rz) of the second surface in the longitudinal direction of the metal plate is 0.2 µm to 1.0 µm, and an arithmetic average roughness (Ra) of the second surface in the width direction of the metal plate is 1.0 µm to 3.0 µm,

10. The deposition mask of claim 1, wherein the large surface hole is a region through which the deposition material introduces, and the small surface hole is a region through which the deposition material introduced from the large surface hole passes.
